# EUROPEAN PATENT SPECIFICATION

(11) **EP 3 059 764 B1**
(45) Date of publication and mention of the grant of the patent: **28.04.2021**
(21) Application number: 15155505.9
(22) Date of filing: 18.02.2015
(51) Int. Cl.: H01L 25/16, H01L 33/46, H01L 33/54, H01L 33/58

(54) **Apparatus for emitting light and method of manufacturing the same**
Vorrichtung zur Ausstrahlung von Licht und Herstellungsverfahren dafür
Appareil pour émettre de la lumière et son procédé de fabrication

(43) Date of publication of application: 24.08.2016
(73) Proprietor: Nokia Technologies Oy, 02610 Espoo (FI)
(72) Inventor: Lasarov, Harri, 02280 Espoo (FI); Blomqvist, Kim, 02650 Espoo (FI)
(74) Representative: Swindell & Pearson Limited

(56) References cited:
- EP-A1- 1 622 237
- DE-A1-102012 109 183
- TW-A- 201 347 218
- US-A1- 2009 156 913
- US-A1- 2013 075 764
- US-B1- 8 362 496

## Description

### TECHNOLOGICAL FIELD

Examples of the present disclosure relate to an apparatus for emitting light and a method for manufacturing the same. Some examples, though without prejudice to the foregoing, relate to an apparatus for use with a photoplethysmography sensor.

### BACKGROUND

Optical heart rate monitors using photoplethysmography (PPG) for measuring a user's pulse are known. PPG sensors are typically constructed using LED(s) as light sources and photodetector(s) as light sensors. Light from the LED(s) is directed towards a user's body part, such as wrist tissue. Light reflected from the wrist tissue is detected by the photodetector(s). Changes in the tissue, e.g. due to pulsating blood, can be determined from a variation in the intensity of the detected reflected light, i.e. an AC component of a photoplethysmographic signal. It is useful to enable PPG sensors to operate efficiently. Conventional configurations of light sources in PPG sensors are not always optimal. Conventional PPG sensors may, for example, suffer from 'internal light pollution' (ILP) where unwanted 'stray' light is detected by the photodetector, such as light directly from the LED or light that is not reflected from the wrist tissue but is reflected from a surface internal of the sensor, which contributes to an unwanted DC component of a photoplethysmographic signal.

US 8362496 B1 discloses an optical module package unit including a light-emitting chip and a light sensor chip respectively installed in a light-emitting zone and a light-sensing zone on a substrate, a lid of plastic shell integrally formed on the substrate and defining therein a first cavity and a second cavity around the light-emitting chip and the light sensor chip respectively, and two packaging adhesive structures respectively moulded in the first cavity and the second cavity to encapsulate the light-emitting chip and the light sensor chip respectively. The light-emitting chip and the light sensor chip are integrally packaged on the substrate.

US 2013/0075764 A1 discloses an optical module package structure including a light-emitting chip and a light sensor chip respectively installed in a first cavity and a second cavity in a substrate, a reflective layer coated on the periphery of the first cavity, two packaging adhesive structures respectively moulded in the first cavity and the second cavity to encapsulate the light-emitting chip and the light sensor chip respectively, and a lid integrally formed on the substrate to enhance the airtightness of the whole optical module package structure.

The listing or discussion of any prior-published document or any background in this specification should not necessarily be taken as an acknowledgement that the document or background is part of the state of the art or is common general knowledge. One or more aspects/examples of the present disclosure may or may not address one or more of the background issues.

### BRIEF SUMMARY

The present invention is as set out in the independent claims.

According to the invention there is provided an apparatus comprising: a light emitting means embedded in an encapsulating medium, wherein at least a part of a surface of the encapsulating medium is configured to prevent a leakage of light therethrough, and wherein the encapsulating medium comprises an elastomeric material.

### BRIEF DESCRIPTION OF THE DRAWINGS

For a better understanding of various examples of the present disclosure that are useful for understanding the detailed description and certain embodiments of the invention, reference will now be made by way of example only to the accompanying drawings in which:
Figure 1 schematically illustrates an apparatus according to an aspect of the present disclosure;
Figure 2 schematically illustrates a plan view of the apparatus of Figure 1;
Figure 3 schematically illustrates a yet further apparatus according to the present disclosure;
Figure 4 schematically illustrates a method according to an aspect of the present disclosure; and
Figures 5A to 5D schematically illustrate steps in the manufacture of an apparatus in accordance with the present disclosure.

The Figures are not necessarily to scale. Certain features and views of the figures may be shown schematically or exaggerated in scale in the interest of clarity and conciseness.

The examples of the present disclosure and the accompanying claims may be suitably combined in any manner apparent to one of ordinary skill in the art.

### DETAILED DESCRIPTION

An example of an apparatus according to the present disclosure will now be described with reference to the Figures. Similar reference numerals are used in the Figures to designate similar features. For clarity, all reference numerals are not necessarily displayed in all Figures.

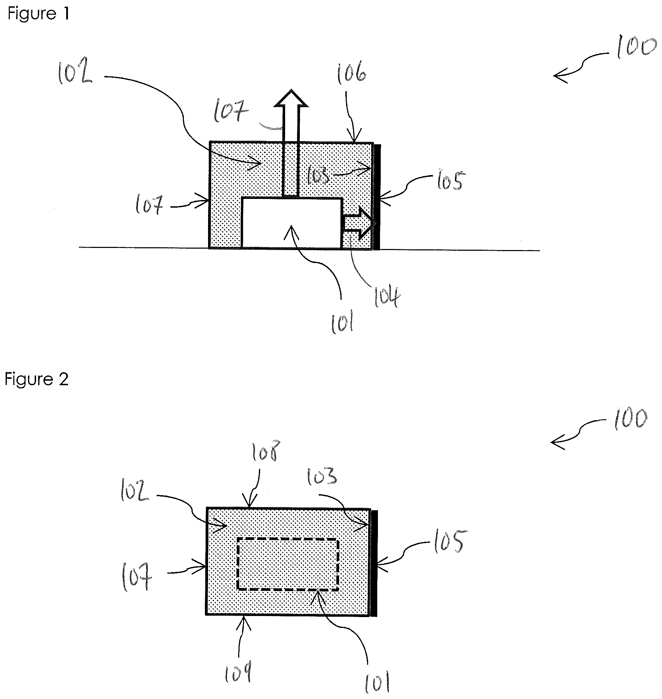

Figure 1 schematically illustrates a block diagram of an apparatus 100 according to an example of the present disclosure. Figure 1 focuses on the functional components necessary for describing the operation of the apparatus.

The apparatus 100 comprises a light emitting means 101 embedded in an encapsulating medium 102, wherein at least a part of a surface 103 of the encapsulating medium is configured to prevent a leakage of light 104 therethrough. For example, the part of the surface 103 of the encapsulating medium 102 may be configured to block/prevent the transmission of light therethrough by being provided with a coating 105 of a material which forms a barrier structure for preventing the leakage/transmission of light therethrough. Certain examples of the apparatus may thereby provide a unitary embedded light emitting structure with an integrated optical barrier.

The light emitting means 101 may be any suitable means for emitting light such as one or more light emitting elements or devices, not least for example one or more Light Emitting Diodes (LEDs). In some examples the light emitting means may be configured to emit light at one or more wavelengths, for instance: infrared, near infrared, red and/or green wavelength bands.

The encapsulating medium 102 may be moulded or casted directly onto the light emitting means 101 so as to substantially envelope/cover and be in direct contact with the light emitting means, or at least the light emitting region thereof. The encapsulating medium may be in direct contact with the light emitting means such that a proximal/inner surface of the encapsulating medium and a distal/outer surface of the light emitting means are in direct contact with one another such that there is no air gap therebetween. The encapsulating medium comprises an an elastomeric material. The encapsulating medium may be optically transparent such that it is translucent to visible and/or infrared light. In some examples, the encapsulating medium may be transmissive to the: infrared, near infrared, red and/or green wavelength bands that the light emitting means operates at. In some examples the encapsulating medium may be optical silicone or liquid silicone rubber.

The at least a part of the surface 103 of the encapsulating medium 102 that is configured to prevent leakage / block the transmission of light 104 from the light emitting means may comprise coating the surface with a light blocking material 105, e.g. a covering layer of an opaque material, thereby forming a barrier structure to prevent the transmission of light through the surface and its coating. Such a provision of a light blocking coating material (e.g. opaque/non-transparent material, not least for example black pigment) on the surface of the encapsulating medium provides a light blocking barrier structure which is formed directly on the light emitting means 101 itself.

Figure 1 shows a cross-sectional view of the apparatus 100 whilst Figure 2 shows a plan view of the apparatus 100. The encapsulating medium 102 is shown having an upper surface 106, distal from the light emitting means 101, and one or more side walls 103, 107, 108, 109. One of the side walls 103 is coated in the light blocking material 105, whereas the upper surface 106 is devoid of any such coating thereby permitting the passage of light 107 therethrough. One or more of the other surfaces, not least for example side walls 107, 108 and 109 may also be devoid of the light blocking coating thus enabling the transmission of light 107 therethrough. In some examples, each of the side walls is provided with the coating.

The component blocks of Figure 1 are functional and the functions described may or may not be performed by a single physical entity. For examples, the apparatus may comprise one or more light emitting means and/or one or more light detecting means.

In certain examples, the apparatus 100 may be configured for use as a part of a photoplethysmography (PPG) sensor, for instance providing the light source in a PPG sensor/PPG sensor module.

Previous PPG sensors provided separate discrete optical barriers between a light source, such as an LED, and a laterally disposed light detector, such as a photodiode, so as to reduce / avoid "Internal Light Pollution" (ILP), namely reduce the detection of unwanted stray light, which contributes to a DC component of a Photoplethysmographic signal. Such stray light may comprise light not reflected from a particular desired part of a user's body (such as a particular tissue region) from where PPG measurements might optimally be made, but instead light that has merely gone directly from the LED to the photodiode or indirectly via a reflection from one or more other surfaces such as internal surfaces of the PPG. Previous optical barriers had to be of sufficient height above the LED (e.g. around 0.2 mm) so as to effectively block unwanted stray light. This could lead to an increase in the size/height of the sensor as well as giving rise to an undesirable air gap above the LED.

Certain examples of the present disclosure provide an apparatus having an optical barrier integrated with an embedded light emitting structure, i.e. a surface of the encapsulating medium being coated in a light blocking material. Certain examples of the present disclosure provide an apparatus that removes the need for separate / discrete optical barriers and may provide a more compact apparatus, i.e. of reduced dimensions (not least height and width) as well as avoiding/minimising the presence of air gaps.

The separate / discrete optical barriers between the laterally spaced apart LED and photodiode of previous PPG sensors were typically made of a rigid inflexible material, such as plastic. Due to manufacturing tolerances, this could lead to an inadequately tight fit with an overlaying protective layer of the sensor, such as an optically transparent protection window, for instance a glass window, to seal the LED and photodiode within the sensor against dust and moisture. Such inadequately tight fitting optical barriers of previous PPG sensors may enable light to leak past the optical barrier, i.e. through the non-tight fit to the photodiode.

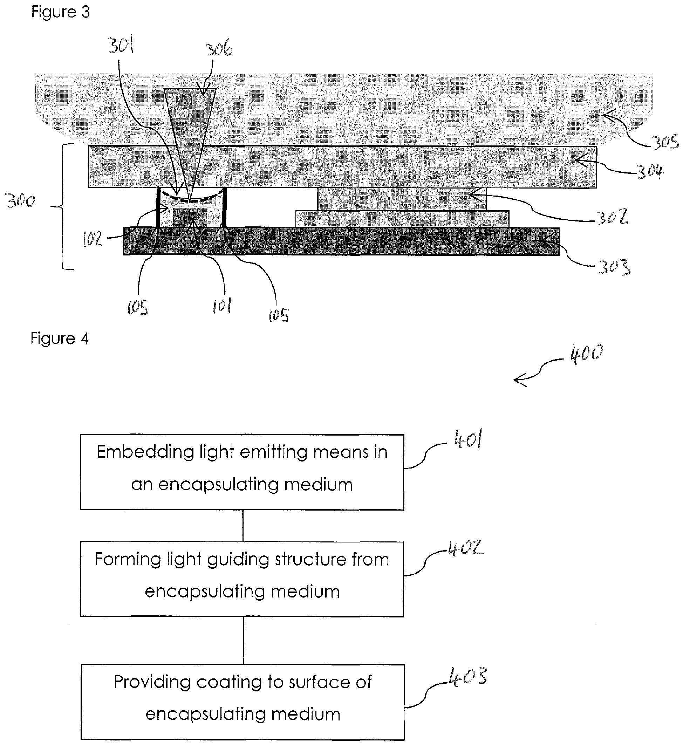

Certain examples of the present disclosure provide an apparatus having an optical barrier integrated with an embedded light emitting structure, i.e. a surface of the encapsulating medium being coated in a light blocking material. Where the encapsulating medium is an elastomeric material, this provides an optical barrier having a degree of flexibility which may enable an improved fit and seal with an overlaying protective layer (see for example Figure 3) which may reduce light leakage / stray light from the light emitting means to a light detector sensor.

Figure 3 shows a further example of an apparatus 300 according to the present disclosure. The light emitting means is mounted on a substrate 303, for example a printed circuit board or a flexible circuit board. Also mounted on the printed circuit board is a light detecting means 302, for instance a light sensor or detecting element such as a photodiode. The light emitting means 101 and the light detecting means 302 may be laterally spaced apart from one another, for instance in certain particular examples by a separation distance of a gap of two to three millimetres.

In some examples, only the light emitting means is embedded in the encapsulating medium (thereby forming an embedded light emitting structure), i.e. the light detecting means is not itself also be embedded and is devoid of any encapsulating medium. In some examples, one or more surfaces of the encapsulating medium is configured to block light from the light emitting means being directly incident (i.e. without any reflections) to the light detecting means.

In some examples, a protective structure 304 may be provided as a protection layer/window for sealing the light emitting means and light detecting means from dust and moisture. The protective structure may be transparent, e.g. a glass panel/window, thereby providing an optically transparent method of sealing. The protective structure may for a part of a housing of the apparatus or a part of an external housing of a device comprising the apparatus. Additional housing elements for the apparatus may also be provided (but are not illustrated).

The apparatus 300 may be configured such one or more parts of the encapsulating medium 102, e.g. the distal perimetral edges of the concave shaped upper surface of the encapsulating medium, abut against and/or is in direct contact with the protective structure 304 thereby forming a seal therewith.

The apparatus 300 may be configured such that light 306 from the light emitting means 101 is directed towards an object such as a user's body part 305, for instance tissue of a user's wrist, whereby light reflected from the object is detected by the light detecting means 302.

In certain examples, signals and measurements from light detecting means may be analysed and processed by controller, for instance circuitry or a processor and memory, and used to determine one or more of: a biometric measurement, a physiological measurement, a photoplethysmogram measurement, a polymetric measurement, a blood volume saturation measurement, a cardio-vascular measurement or heart rate measurement.

As shown in Figure 3, the encapsulating medium 102 may be configured such to provide a light guiding structure 301. The light guiding structure may be configured so as to re-direct/focus light from the light emitting means 101 to a particular direction or so as to have a particular beam shape 306, e.g. a narrow beam shape directed at a particular area of body tissue so as to increase light intensity incident at the particular tissue area (i.e. an optimal area suitable for PPG measurements) whose reflections there from are detected to provide the desired AC component of a photoplethysmographic signal and minimise unwanted DC components of the photoplethysmographic signal, e.g. detected light reflected from areas / surfaces other than the particular tissue area. In this regard, the shape or structure of the encapsulating medium may be configured so as to provide light guiding means. For example, the shape of the encapsulating medium 102 may be configured so as to re-direct the light from the light emitting means. For instance, the encapsulating medium may be provided with a curved shape, a concave shape, a convex shape or some other optical shape on one or more of its surfaces, not least for example the upper surface 106, so as to re-direct/focus light. Alternatively, or in addition, the encapsulating medium may comprise a diffractive element configured to re-direct light. For instance, a surface of the encapsulating medium may be structured so as to provide diffractive optical elements, for examples grooves or gratings, configured to re-direct light.

The encapsulating medium/light guide may be optimised so as to re-direct light in specific wavelength bands, not least for example one or more of: infrared, near infrared, red and green wavelength regions.

Certain examples of the present disclosure provide an apparatus having an encapsulating medium configured as a light guide/focusing element. This may enable an increase in the signal to noise ratio for PPG measurements by enabling the focusing of light to a particular region for a user's body optically suited for PPG measurements. This may maximise the amount of light reflected in such a region and detected by the light detecting means. This may enable a reduction in the required brightness of light source, enabling a lower current to be used and reduced the power consumption thereby prolonging battery life and operational time of the apparatus. Also, such focusing may reduce the amount of unwanted light and stray reflections from other surfaces and other regions of the user's body parts which are unsuitable for PPG readings.

In some examples, one or more surfaces of the encapsulating medium may comprise a reflective coating so as to increase the amount of light outputted in a particular desired direction, i.e. outputted from the upper surface. In some examples, the coating of the light blocking material may overlay the reflective coating.

Without limiting the scope of the claims, an advantage of some examples of the present disclosure may be to provide a sensor module of reduced dimensions / more compact form factor. This not only enables less materials to be used during manufacture of the apparatus, but also enables the apparatus itself and its components, not least the light emitting means (and light detector) to be closer to the user's body and more comfortably worn by a user for prolonged periods. By enabling the light emitting means and light detector to be located more proximal to a user's skin, the optical path length of light emitted from the light emitting means, reflected from the user's tissue and detected at the light detection means is reduced, and thus the intensity of light incident to the tissue and intensity of light reflected and detected therefrom may be increased.

The apparatus may be provided as a module, such as PPG sensor module. The apparatus may be provided with one or more light emitting means as well as one or more light detecting means which may be configured/optimised for particular wavelength bands, for example one or more colour channels not least for instance: infrared, nearer infrared, red and green.

The apparatus and module may be provided in a device, at least, for example, a device configured for: portable use, handheld use and/or wearable use. The device may also be configured to provide additional functionality, not least for example wireless communication. The device may comprise a controller, for example, circuitry such as processor and memory for controlling the light emitting means and the light detecting means and determining PPG and other physiological readings/measurements therefrom.

In some examples, the device may be configured as a wrist wearable device having a band-like or strap type form factor configured to enclose or wrap around a user's wrist.

The present disclosure also extends to methods of manufacturing the above described apparatuses.

Figure 4 shows an example of a method 400 according to the present disclosure. In block 401, a light emitting means 101 is embedded in an encapsulating medium 102. This may comprise applying the encapsulating medium, such as optical silicone, directly onto the light emitting means, such as an LED. In some examples, the encapsulating medium may be directly moulded or casted onto the light emitting means.

In block 402 a light guiding structure / desired optical structure 301 is formed from the encapsulating medium. The light guiding structure may comprise a shape and/or structure imparted to the encapsulating medium. For instance, a dome shape and/or a diffractive structure applied to a surface of the encapsulating medium. In some examples, this may be done as part of a moulding/casting process.

In block 403 at least a part of a surface of the encapsulating medium is configured so as to prevent a leakage of light therethrough. For example, a coating may be applied to the surface of the encapsulating medium. The coating may be a thin coating of a material that prevents the passage of light through the surface coating. In some examples, the material is a light blocking, opaque and/or non-transparent material 105. In some examples, once the moulded edges of the encapsulating medium have been formed thereby defining an upper surface and side walls, the side walls may be coated so as to be black such that light is prevented from leaking out of the side walls. Prior to the application of a light blocking coating, a reflective coating could be applied to the side walls so as to increase light reflections inside the embedded LED structure. A further coating could be applied overlaying the reflective coating, such overlaying coating comprising the coating of a light blocking material.

The flowchart of Figure 4 represents one possible scenario among others. In certain examples one or more blocks may be performed in a different order or overlapping in time, in series or in parallel. For example blocks 401 and 402 may be performed in the same moulding/casting step. One or more blocks may be omitted or added or changed in some combination of ways. The order of the blocks shown is not absolutely required, so in principle, the various blocks can be performed out of order, for example blocks 402 and 403 could be performed in opposite order. Not all the blocks are essential, for example block 402 could be omitted.

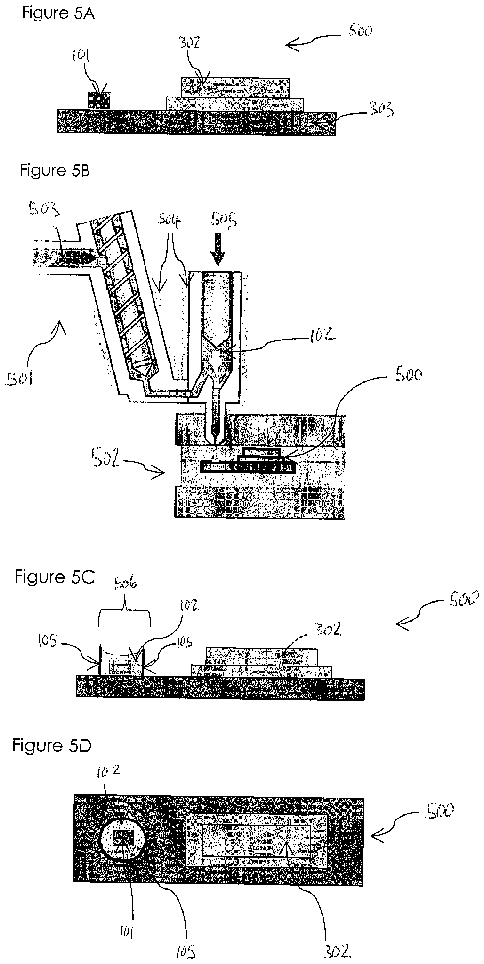

Figures 5A to 5D schematically illustrate steps of a method of manufacturing an apparatus according to the present disclosure.

In Figure 5A a sensor module 500 is provided comprising the light emitting means 101 mounted on a printed circuit board 303. A light detecting means 302 is mounted on a printed circuit board 303 alongside the light emitting means. The sensor module may be a standard PPG sensor module but without an injection moulded plastic frame.

In Figure 5B, a moulding or casting apparatus 501 is used to mould or cast molten thermosetting elastomeric encapsulating material 102 directly onto the light emitting means of the sensor module 500. Here, the sensor module 500 is inserted into a moulding tool 502 such that the encapsulating medium may be directly moulded and cast onto the light emitting means. The encapsulating medium is fed into a static mixer 503 and cooled down by cooling jackets 504 of the moulding/casting apparatus 501. The encapsulating medium is applied, via the application of feeding pressure 505, directly to the light emitting means of the sensor 500 held within the moulding tool 502.

Figure 5C shows an optical structure/light guiding structure 301 of the encapsulating medium 102. In some examples, a shape and/or diffractive elements may be formed on a surface of the encapsulating medium to form the optical structure/light guiding structure 301. The optical structure/light guiding structure 301 may be formed on the encapsulating medium 102 as part of the moulding/casting process. In some examples, the optical structure is formed and applied separately of the moulding/casting process.

The side walls of the encapsulating medium are coated in the light blocking material 105 thereby providing a sensor module with an embedded light emitting structure 506.

Figure 5D shows the apparatus 500 with its embedded light emitting structure 506 from a plan perspective. A protecting window 304 (not shown) may be provided so as to overlay the apparatus 500 to protect the components, not least the embedded light emitting structure 506 and the light detecting means 302, from dust and moisture.

Although examples of the apparatus have been described above in terms of comprising various components, it should be understood that the components may be embodied as or otherwise controlled by a corresponding controller or circuitry such as one or more processing elements or processor. In this regard, each of the components described below may be one or more of any device, means or circuitry embodied in hardware, software or a combination of hardware and software that is configured to perform the corresponding functions of the respective components as described above.

As used in this application, the term 'circuitry' refers to all of the following:
(a) hardware-only circuit implementations (such as implementations in only analogue and/or digital circuitry) and
(b) to combinations of circuits and software (and/or firmware), such as (as applicable): (i) to a combination of processor(s) or (ii) to portions of processor(s)/software (including digital signal processor(s)), software, and memory(ies) that work together to cause an apparatus, such as a mobile phone or server, to perform various functions) and
(c) to circuits, such as a microprocessor(s) or a portion of a microprocessor(s), that require software or firmware for operation, even if the software or firmware is not physically present.

This definition of 'circuitry' applies to all uses of this term in this application, including in any claims. As a further example, as used in this application, the term "circuitry" would also cover an implementation of merely a processor (or multiple processors) or portion of a processor and its (or their) accompanying software and/or firmware. The term "circuitry" would also cover, for example and if applicable to the particular claim element, a baseband integrated circuit or applications processor integrated circuit for a mobile phone or a similar integrated circuit in a server, a cellular network device, or other network device.

The apparatus may be provided in a module. As used here 'module' refers to a unit or apparatus that excludes certain parts/components that would be added by an end manufacturer or a user.

In certain examples, the apparatus may be embodied in an electronic device, that may additionally provide: one or more audio/text/video communication functions (e.g. tele-communication, video-communication, and/or text transmission (Short Message Service (SMS)/ Multimedia Message Service (MMS)/emailing) functions), interactive/non-interactive viewing functions (e.g. web-browsing, navigation, TV/program viewing functions), music recording/playing functions (e.g. Moving Picture Experts Group-1 Audio Layer 3 (MP3) or other format and/or (frequency modulation/amplitude modulation) radio broadcast recording/playing), downloading/sending of data functions, image capture function (e.g. using a (e.g. in-built) digital camera), and gaming functions.

In some examples, the apparatus may be provided in a wearable device such as a wrist wearable device. It should be understood, however, that a wearable device is merely illustrative of an electronic device that would benefit from examples of implementations of the present disclosure and, therefore, should not be taken to limit the scope of the present disclosure to the same.

In the above description, the apparatus described may alternatively or in addition comprise an apparatus which in some other embodiments comprises a distributed system of apparatus, for example, a client/server apparatus system. For example, the apparatus may be provided as a sensor module for a device which sends sensor measurements to a remote device for processing and analysis, e.g. to determine PPG signals and/or physiological readings therefrom. In examples of embodiments where an apparatus provided forms a distributed system, each apparatus forming a component and/or part of the system provides (or implements) one or more features which collectively implement an example of the present disclosure.

Examples of the present disclosure provide both an apparatus and corresponding method for manufacturing the same. The apparatus may comprise various means, components that may be under the control of a controller/circuitry for providing the above described functionality. The controller/circuitry may be implemented as hardware, or may be implemented as software or firmware to be performed by a computer processor. In the case of firmware or software, examples of the present disclosure can be provided as a computer program product including a computer readable storage structure embodying computer program instructions (i.e. the software or firmware) thereon for performing by the computer processor.

Features described in the preceding description may be used in combinations other than the combinations explicitly described.

Although functions have been described with reference to certain features, those functions may be performable by other features whether described or not. Although features have been described with reference to certain examples, those features may also be present in other examples whether described or not. Although various examples of the present disclosure have been described in the preceding paragraphs, it should be appreciated that modifications to the examples given can be made without departing from the scope of the invention as set out in the claims. For example one or more light emitting means embedded in an encapsulating medium may be provided.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one ..." or by using "consisting".

In this description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some or all other examples. Thus 'example', 'for example' or 'may' refers to a particular instance in a class of examples. A property of the instance can be a property of only that instance or a property of the class or a property of a sub-class of the class that includes some but not all of the instances in the class.

In this description, references to "a/an/the" [feature, element, component, means ...] are to be interpreted as "at least one" [feature, element, component, means ...] unless explicitly stated otherwise.

The above description describes some examples of the present disclosure however those of ordinary skill in the art will be aware of possible alternative structures and method features which offer equivalent functionality to the specific examples of such structures and features described herein above and which for the sake of brevity and clarity have been omitted from the above description

## Claims

1. An apparatus (100) comprising:
a light emitting means (101) embedded in an encapsulating medium (102), wherein at least a part of a surface (103) of the encapsulating medium is coated in a material (105) configured to form a barrier structure to prevent a leakage of light (104) therethrough, and **characterized in that** the encapsulating medium (102) comprises an elastomeric material.

2. The apparatus (100) of any one or more of the previous claims, wherein the encapsulating medium (102) is moulded or casted directly onto the light emitting means (101).

3. The apparatus (100) of any one or more of the previous claims, wherein the encapsulating medium (102) is configured to provide a light guiding structure, and/or wherein a shape of encapsulating medium is configured to re-direct light from the light emitting means.

4. The apparatus (100) of any one or more of the previous claims, wherein the encapsulating medium (102) comprises diffractive elements configured to re-direct light from the light emitting means.

5. The apparatus (100) of any one or more of the previous claims, further comprising a protective layer (304) overlaying the encapsulating medium (102), wherein at least a part of the encapsulating medium is configured to be in contact with the protective layer.

6. The apparatus (100) of claim 5, wherein at least a part of the encapsulating medium (102) is configured to form a seal with the protective layer (304).

7. The apparatus (100) of claim 5 or 6, wherein the protective layer (304) comprises a protective window structure.

8. The apparatus (100) of any one or more of the previous claims, wherein the at least a part of a surface of the encapsulating medium (102) further comprises a reflective coating.

9. The apparatus (100) of any one or more of the previous claims, further comprising a light sensing means (302), and wherein the apparatus is configured to direct light from the light emitting means (101) to an object (305) and wherein the light sensing means is configured to detect light reflected from said object.

10. The apparatus (100) of claim 9, further comprising a protective layer (304) overlaying the encapsulating medium (102) and the light sensing means (302), wherein at least a part of the encapsulating medium is configured to be in contact with the protective layer.

11. The apparatus (100) of any one or more of the previous claims, wherein the apparatus is configured for use in determining one or more of:
a biometric measurement, a physiological measurement, a photoplethysmogram measurement, a volumetric measurement,
a blood oxygen saturation measurement, a cardiovascular measurement or heart rate measurement.

12. A module comprising the apparatus (100) of any one or more of the previous claims.

13. A device comprising the apparatus (100) of any one or more of previous claims 1 to 11, or the module of claim 12.

14. The device of claim 13, wherein the device is configured for at least one of: portable use, handheld use, wearable use and wireless communication.

## Patentansprüche

1. Einrichtung (100), die Folgendes umfasst:
ein lichtemittierendes Mittel (101), das in ein Kapselungsmedium (102) eingebettete ist, wobei mindestens ein Teil einer Fläche (103) des Kapselungsmediums mit einem Material (105) beschichtet ist, das dazu ausgelegt ist, eine Sperrstruktur zu bilden, um eine Leckage von Licht (104) dadurch zu verhindern, und **dadurch gekennzeichnet, dass** das Kapselungsmedium (102) ein Elastomermaterial umfasst.

2. Einrichtung (100) nach einem oder mehreren der vorhergehenden Ansprüche, wobei das Kapselungsmedium (102) direkt auf das lichtemittierende Mittel (101) aufgeformt oder gegossen ist.

3. Einrichtung (100) nach einem oder mehreren der vorhergehenden Ansprüche, wobei das Kapselungsmedium (102) dazu ausgelegt ist, eine Lichtführungsstruktur bereitzustellen, und/oder wobei eine Form des Kapselungsmediums dazu ausgelegt ist, Licht vom lichtemittierenden Mittel umzuleiten.

4. Einrichtung (100) nach einem oder mehreren der vorhergehenden Ansprüche, wobei das Kapselungsmedium (102) Brechungselemente umfasst, die dazu ausgelegt sind, Licht vom lichtemittierenden Mittel umzuleiten.

5. Einrichtung (100) nach einem oder mehreren der vorhergehenden Ansprüche, die ferner eine Schutzschicht (304) umfasst, die das Kapselungsmedium (102) überlagert, wobei mindestens ein Teil des Kapselungsmediums dazu ausgelegt ist, mit der Schutzschicht in Kontakt zu sein.

6. Einrichtung (100) nach Anspruch 5, wobei mindestens ein Teil des Kapselungsmediums (102) dazu ausgelegt ist, mit der Schutzschicht (304) eine Dichtung zu bilden.

7. Einrichtung (100) nach Anspruch 5 oder 6, wobei die Schutzschicht (304) eine Schutzfensterstruktur umfasst.

8. Einrichtung (100) nach einem oder mehreren der vorhergehenden Ansprüche, wobei der mindestens eine Teil einer Fläche des Kapselungsmediums (102) ferner eine reflektierende Schicht umfasst.

9. Einrichtung (100) nach einem oder mehreren der vorhergehenden Ansprüche, die ferner ein Lichterfassungsmittel (302) umfasst und wobei die Einrichtung dazu ausgelegt ist, Licht vom lichtemittierenden Mittel (101) zu einem Objekt (305) zu leiten, und wobei das Lichterfassungsmittel dazu ausgelegt ist, Licht, das vom Objekt reflektiert wird, zu detektieren.

10. Einrichtung (100) nach Anspruch 9, die ferner eine Schutzschicht (304) umfasst, die das Kapselungsmedium (102) und das Lichterfassungsmittel (302) überlagert, wobei mindestens ein Teil des Kapselungsmediums dazu ausgelegt ist, mit der Schutzschicht in Kontakt zu sein.

11. Einrichtung (100) nach einem oder mehreren der vorhergehenden Ansprüche, wobei die Einrichtung zur Verwendung zum Bestimmen von einem oder mehrerem von Folgendem ausgelegt ist:
einer biometrischen Messung, einer physiologischen Messung, einer photoplethysmografischen Messung, einer volumetrischen Messung, einer Blutsauerstoffsättigungsmessung, einer kardiovaskulären Messung oder einer Herzfrequenzmessung.

12. Modul, das die Einrichtung (100) nach einem oder mehreren der vorhergehenden Ansprüche umfasst.

13. Vorrichtung, die die Einrichtung (100) nach einem oder mehreren der vorhergehenden Ansprüche 1 bis 11 oder das Modul nach Anspruch 12 umfasst.

14. Vorrichtung nach Anspruch 13, wobei die Vorrichtung für mindestens eines von Folgendem ausgelegt ist: portable Verwendung, Handverwendung, tragbare Verwendung und drahtlose Kommunikation.

## Revendications

1. Appareil (100) comprenant :
un moyen d'émission de lumière (101) incorporé dans un milieu d'encapsulation (102), dans lequel au moins une partie de surface (103) du milieu d'encapsulation est revêtue d'un matériau (105) conçu pour former une structure de barrière afin d'empêcher une fuite de lumière (104) à travers celle-ci, et **caractérisé en ce que** :
le milieu d'encapsulation (102) comprend une matière élastomère.

2. Appareil (100) selon une ou plusieurs quelconque(s) des revendications précédentes, dans lequel le milieu d'encapsulation (102) est moulé ou coulé directement sur le moyen d'émission de lumière (101).

3. Appareil (100) selon une ou plusieurs quelconque(s) des revendications précédentes, dans lequel le milieu d'encapsulation (102) est conçu pour procurer une structure de guidage de lumière, et/ou dans lequel une forme du milieu d'encapsulation est conçue pour rediriger la lumière provenant du moyen d'émission de lumière.

4. Appareil (100) selon une ou plusieurs quelconque(s) des revendications précédentes, dans lequel le milieu d'encapsulation (102) comprend des éléments diffractifs conçus pour rediriger la lumière provenant du moyen d'émission de lumière.

5. Appareil (100) selon une ou plusieurs quelconque(s) des revendications précédentes, comprenant en outre une couche de protection (304) superposée au milieu d'encapsulation (102), dans lequel au moins une partie du milieu d'encapsulation est conçue pour être en contact avec la couche de protection.

6. Appareil (100) selon la revendication 5, dans lequel au moins une partie du milieu d'encapsulation (102) est conçue pour former un joint d'étanchéité avec la couche de protection (304).

7. Appareil (100) selon la revendication 5 ou 6, dans lequel la couche de protection (304) comprend une structure de fenêtre de protection.

8. Appareil (100) selon une ou plusieurs quelconque(s) des revendications précédentes, dans lequel l'au moins une partie de surface du milieu d'encapsulation (102) comprend en outre un revêtement réfléchissant.

9. Appareil (100) selon une ou plusieurs quelconque(s) des revendications précédentes, comprenant en outre un moyen de détection de lumière (302) et dans lequel l'appareil est conçu pour diriger la lumière provenant du moyen d'émission de lumière (101) vers un objet (305) et dans lequel le moyen de détection de lumière est conçu pour détecter la lumière réfléchie par ledit objet.

10. Appareil (100) selon la revendication 9, comprenant en outre une couche de protection (304) superposée au milieu d'encapsulation (102) et au moyen de détection de lumière (302), dans lequel au moins une partie du milieu d'encapsulation est conçue pour être en contact avec la couche de protection.

11. Appareil (100) selon une ou plusieurs quelconque(s) des revendications précédentes, dans lequel l'appareil est conçu pour être utilisé dans la détermination de :
une mesure biométrique et/ou une mesure physiologique et/ou une mesure photopléthysmographique et/ou une mesure volumétrique et/ou une mesure de saturation en oxygène du sang et/ou une mesure cardiovasculaire et/ou une mesure de fréquence cardiaque.

12. Module comprenant l'appareil (100) selon une ou plusieurs quelconque(s) des revendications précédentes.

13. Dispositif comprenant l'appareil (100) selon une ou plusieurs quelconque(s) des revendications 1 à 11 précédentes ou le module selon la revendication 12.

14. Dispositif selon la revendication 13, dans lequel le dispositif est conçu pour une utilisation portable et/ou pour être utilisé porté à la main et/ou pour être utilisé porté sur soi et/ou pour la communication sans fil.
